# EUROPÄISCHE PATENTSCHRIFT

(11) **EP 0 263 434 B1**
(45) Veröffentlichungstag und Bekanntmachung des Hinweises auf die Patenterteilung: **13.04.1994**
(21) Anmeldenummer: 87114323.6
(22) Anmeldetag: 01.10.1987
(51) Int. Cl.: G03F 7/004, G03F 7/022

(54) **Lichtempfindliches Gemisch und hieraus hergestelltes lichtempfindliches Kopiermaterial**
Photosensitive composition and a photosensitive registration material prepared therefrom
Composition photosensible et matériel pour l'enregistrement photosensible préparé à base de cette composition

(30) Priorität: 09.10.1986 DE 3634371
(43) Veröffentlichungstag der Anmeldung: 13.04.1988
(73) Patentinhaber: HOECHST AKTIENGESELLSCHAFT, 65926 Frankfurt am Main (DE)
(72) Erfinder: Stahlhofen, Paul, Dr. Dipl.-Chem., D-6200 Wiesbaden (DE); Vollmann, Hansjörg, W., Dr. Dipl.-Chem., D-6232 Bad Soden-Neuenhain (DE); 1Guzzi, Alberto, Dr. Dipl.-Chem., D-37138 Verona (IT)

(56) Entgegenhaltungen:
- EP-A- 0 111 273
- EP-A- 0 133 216
- EP-A- 0 164 248
- DE-A- 1 447 919

## Beschreibung

Die Erfindung betrifft ein lichtempfindliches Gemisch, das im wesentlichen ein wasserunlösliches, in wäßrig-alkalischen Lösungen lösliches Bindemittel, eine thermisch vernetzende Verbindung und entweder a) ein lichtempfindliches 1,2-Chinondiazid oder b) eine bei Belichtung Säure abspaltende Verbindung und eine Verbindung mit mindestens einer durch Säure spaltbaren C-O-C-Gruppe und enthält. Die Erfindung betrifft auch ein hieraus hergestelltes Kopiermaterial.

Lichtempfindliche Gemische, deren bildmäßig belichtete Bereiche in einer Entwicklerlösung löslich werden und in der die unbelichteten Bereiche unlöslich sind, sind seit langem bekannt. Für die Herstellung derartiger Materialien werden in der Praxis vor allem Schichten mit o-Chinondiaziden als lichtempfindliche Verbindungen verwendet, die noch Harze mit alkalilöslich machenden Gruppen enthalten, z.B. Phenolharze.

Lichtempfindliche Gemische auf Basis säurespaltbarer Verbindungen sind ebenfalls bekannt. Sie enthalten als säurespaltbare Verbindungen Orthocarbonsäurederivate, monomere oder polymere Acetale, Enolether oder Acyliminocarbonate. Als strahlungsempfindliche, Säure abspaltende Verbindungen enthalten sie vorwiegend organische Halogenverbindungen, insbesondere durch Halogenmethylgruppen substituierte s-Triazine. Als Bindemittel werden auch Harze mit alkalilöslich machenden Gruppen verwendet.

Es ist auch bekannt, daß ein normalerweise positiv arbeitendes Kopiermaterial auf Basis von o-Chinondiaziden in Gegenwart geeigneter Zusatzstoffe durch eine bestimmte Folge von Behandlungen negativ verarbeitet werden kann. In der GB-A 2,082,339 ist ein derartiges Umkehrverfahren beschrieben, bei dem ein lichtempfindliches Gemisch, bestehend aus einem o-Chinondiazid und mindestens einem Resol, als negativ arbeitendes Aufzeichnungsmaterial benutzt werden kann. In der DE-OS 25 29 054 entsprechend US-PS 4,104,070 werden Resistschichten auf Basis von 1,2-Chinondiaziden für ein Umkehrverfahren beschrieben, die als Zusatzstoff Hydroxyethylimidazoline enthalten. Ein ähnliches Material mit einem Gehalt an sekundären oder tertiären Aminen wird in der US-A 4,196,003 beschrieben. In EP-OS 0 133 216 entsprechend US-PS 4,581,321 wird ein Umkehrverfahren beschrieben, welches als Zusatz zur o-Chinondiazid-haltigen Kopierschicht einen Hexamethylolmelaminether enthält, der vorzugsweise als Vernetzungsmittel bei Polymerreaktionen Verwendung findet, während in EP-OS 0 131 238 entsprechend US-PS 4,576,901 ein Umkehrverfahren beschrieben wird, dessen lichtempfindliches Material keinen der oben erwähnten basischen oder sauren Zusätze erfordert.

Bekannt ist ferner ein Positiv-Negativ-Umkehrverfahren aus Basis säurespaltbarer Verbindungen anstelle von 1,2-Chinondiaziden, wie es in EP-OS 0 082 463 entsprechend US-PS 4,506,006 beschrieben ist.

Die genannten Umkehrverfahren enthalten im Prinzip die gleiche Folge von Verarbeitungsschritten, wobei nach der bildmäßigen Belichtung die Druckplatte erwärmt wird, nach dem Abkühlen nochmals ohne Vorlage nachbelichtet und dann mittels eines wäßrig-alkalischen Entwicklers entwickelt wird.

Bekannt sind ferner Verfahren zur Herstellung von Druckformen durch Erhitzen bzw. Einbrennen der nach dem Belichten und Entwickeln resultierenden Druckschablone. Normalerweise werden beim Erhitzen Temperaturen von 220 bis 250 °C angewendet, und die Dauer des Erhitzens beträgt etwa 5 bis 10 Minuten. Durch diese Nachbehandlung wird eine Verfestigung der Druckschicht und damit eine erhebliche Erhöhung der Druckauflage erreicht. Wenn die Einbrenntemperaturen an der oberen Grenze des angegebenen Bereichs liegen, sind naturgemäß relativ kurze Einbrennzeiten erforderlich. Es hat sich gezeigt, daß die Anwendung höherer Temperaturen bei diesem Verfahren nachteilig ist. Sie bewirken einmal die Ausbildung eines verhältnismäßig festsitzenden Niederschlags auf den Hintergrundstellen, der nur durch relativ aggressive Lösungen sauber entfernt werden kann, wobei die Gefahr eines Angriffs auf die Druckschablone besteht. Zum zweiten besteht bei den höheren Einbrenntemperaturen oder bei längeren Einbrennzeiten die Gefahr, daß sich die üblicherweise verwendeten Schichtträger aus Aluminium verformen und die erhaltenen Druckformen geschädigt oder unbrauchbar werden.

Der zuerst genannte Nachteil kann, wie es in der DE-OS 26 26 473 entsprechend GB-PS 1,555,233 beschrieben ist, dadurch vermieden werden, daß man die Hintergrundfläche vor dem Einbrennen mit einer Schicht einer wasserlöslichen organischen Substanz oder eines anorganischen Salzes überzieht, die sich nach dem Einbrennen leicht abwaschen läßt. Um die Verformung des Schichtträgers zu verhindern, wäre es jedoch wünschenswert, bei tieferen Temperaturen einbrennen zu können.

In der DE-A 14 47 919 ist ein lichtempfindliches Gemisch offenbart, das einen 1,2-Naphthochinon-2-diazid-sulfonsäureester, ein alkalibeständiges filmbildendes Bindemittel und bevorzugt noch ein alkalilösliches Bindemittel (Novolak) enthält. Zusätzlich kann es ein polymeres Reaktionsprodukt aus Melamin, Formaldehyd und einem niedermolekularen, einwertigen Alkohol enthalten. Das Gemisch ist geeignet für die Herstellung von Druckplatten, insbesondere Flachdruckplatten, wie auch von Photoresists.

Aus der EP-A 0 164 248 ist ein lichtempfindliches Gemisch bekannt, das eine bei Bestrahlung Säure bildende Verbindung enthält, sowie eine Verbindung, die in Gegenwart dieser Säure in der Wärme mit einer weiteren Verbindung vernetzt. Als Vernetzer dienen u.a. Aminoplaste (^{(R)}Cymel). Die weitere Verbindung ist vorzugsweise ein Novolak.

Auch in EP-A 0 111 273 ist ein lichtempfindliches Gemisch beschrieben, das ein wasserunlösliches, in wäßrigen Lösungen lösliches Bindemittel, ein lichtempfindliches o- oder p-Chinondiazid und eine thermisch vernetzende Verbindung enthält. Die thermisch vernetzende Verbindung ist ein Hexamethylol-melamin, das gegebenenfalls mit einem niederen einwertigen Alkohol verethert ist.

Aus der DE-OS 30 39 926 entsprechend US-PS 4,387,152 ist ein lichtempfindliches Gemisch der beschriebenen Gattung bekannt, das neben einer lichtempfindlichen Verbindung und einem alkalilöslichen Bindemittel ein Phenolderivat mit 2 bis 4 Hydroxymethylgruppen enthält. Durch Zusatz des Phenolderivats läßt sich die Einbrenntemperatur unter 230 °C absenken. Dieses Material hat noch nicht vollbefriedigende Entwicklerresistenz und Lagerfähigkeit.

In EP-OS 0 111 273 wird ein lichtempfindliches Gemisch beschrieben, das neben einer lichtempfindlichen Verbindung und einem alkalilöslichen Bindemittel ein thermisch vernetzendes cyclisches Säureamid enthält, welches ebenfalls das Einbrennen der Kopierschicht erleichtert. Nachteilig hieran ist die relativ geringe Lagerfähigkeit, insbesondere bei erhöhter Temperatur, wodurch die Aufentwicklung der entsprechenden und bildmäßig belichteten Druckplatten erschwert wird.

Aufgabe der Erfindung war es, ein positiv und negativ arbeitendes lichtempfindliches Material auf Basis von 1,2-Chinondiaziden oder auf Basis säurespaltbarer Verbindungen vorzuschlagen, das diese Nachteile nicht besitzt und das Einbrennen bei niedrigeren Temperaturen als bisher üblich, ermöglicht, ohne daß zugleich die Lagerfähigkeit merkbar zurückgeht und ohne daß die kopiertechnischen Eigenschaften nachteilig beeinflußt werden.

Die Erfindung geht aus von einem lichtempfindlichen Gemisch, das im wesentlichen ein wasserunlösliches, in wäßrig-alkalischen Lösungen lösliches Bindemittel, eine thermisch vernetzende Verbindung und entweder a) ein lichtempfindliches 1,2-Chinondiazid oder b) eine bei Belichtung Säure abspaltende Verbindung und eine Verbindung mit mindestens einer durch Säure spaltbaren C-O-C-Gruppe und enthält.

Das erfindungsgemäße Gemisch ist dadurch gekennzeichnet, daß als thermisch vernetzende Verbindung ein nicht gehärtetes, mit niederen Glykolen verethertes Melamin-Formaldehyd-Harz mit einem Molekulargewicht im Bereich von etwa 500 bis 1,500 vorhanden ist.

Die Herstellung der thermisch vernetzenden Verbindung erfolgt durch Kondensation von Melamin mit Formaldehyd in mineralsaurer Lösung bei Zimmertemperatur oder in der Hitze. Die Reaktion wird so geleitet, daß es noch nicht zur völligen Aushärtung der Kondensationsprodukte kommt und letztere in organischen Lösungsmitteln noch löslich sind.

Die Veretherung kann in stark saurer Lösung bei Raumtemperatur durchgeführt werden, wobei eine Reaktionszeit von wenigen Minuten oftmals ausreicht. Vorteilhafterweise wird die Veretherung jedoch in schwach saurer Lösung beim Siedepunkt des angewandten Glykols und unter azeotroper Wasserentfernung durchgeführt. Als Veretherungskomponente werden niedere Glykole wie Butylglykol verwendet.

Entsprechende Herstellungsvorschriften sind beispielsweise in Houben-Weyl:"Methoden der organischen Chemie", Band 14/2, Seite 368, Beispiel 12 und 14 angegeben.

Die nicht gehärteten, mit niederen Glykolen veretherten Melamin-Formaldehyd-Harze zeichnen sich durch gute Beständigkeit gegen Wärmeeinwirkung aus. In Gegenwart von Hydroxyl- oder Carboxylgruppen enthaltenden Bindemitteln, die erfindungsgemäß in der Kopierschicht verwendet werden, reagieren sie bei relativ hoher Hitzeeinwirkung (oberhalb 180 °C) zu unlöslichen und ausgehärteten, dreidimensional vernetzenden Produkten, wobei die Kopierschicht eine ausgezeichnete Abriebfestigkeit erlangt.

Besonders vorteilhaft an der Verwendung der nicht gehärteten, mit niederen Glykolen veretherten Melamin-Formaldehyd-Harze gegenüber den bisher in lichtempfindlichen Schichten zum gleichen Zweck eingesetzten thermisch vernetzenden Verbindungen ist, daß einerseits schon relativ geringe Mengen ausreichen, um das Einbrennen der Kopierschicht bei niedrigeren Temperaturen, als dies bisher in der Praxis üblich war, zu ermöglichen. Andererseits kann bei ihrer entsprechenden Dosierung die Einbrennzeit der Kopierschicht bzw. der fertigen Druckform wesentlich verkürzt werden.

Die erfindungsgemäß beanspruchten Gemische zeichnen sich ferner durch eine wesentlich bessere Lagerfähigkeit aus im Vergleich zu denen, die beispielsweise als vernetzende Verbindungen Hexamethylol-melamin-hexamethylether oder Methylolgruppen enthaltende Phenole enthalten.

Die Konzentration der thermisch vernetzenden mit niederen Glykolen veretherten Melamin-Formaldehyd-Harze in dem lichtempfindlichen Gemisch kann in relativ weiten Grenzen schwanken. Im allgemeinen liegt der Anteil bei 0,5 bis 5, vorzugsweise zwischen 1,0 und 3,0 Gewichtsprozent, bezogen auf das Gewicht der nicht flüchtigen Bestandteile des lichtempfindlichen Gemisches.

Ein weiterer großer Vorteil des erfindungsgemäßen Gemisches besteht darin, daß es, eingesetzt in einem Kopiermaterial, das normalerweise positiv arbeitet, durch eine gezielte Wärmebehandlung auch als negativ arbeitend eingesetzt werden kann. Zu diesem Zweck wird nach der bildmäßigen Belichtung das Material aus Schichtträger und lichtempfindlicher Schicht aus dem erfindungsgemäßen Gemisch ohne weitere Zwischenbehandlung erwärmt. Das Erwärmen kann durch Bestrahlung, Konvektion, durch Kontakt mit erwärmten Flächen, z.B. Walzen, oder durch Tauchen in ein erwärmtes Bad einer inerten Flüssigkeit, z.B. Wasser, erfolgen. Die Temperatur kann zwischen 80 und 150, vorzugsweise bei 100 bis 130 °C liegen. Derartige Temperaturen werden von den Gemischen vertragen, ohne daß die Eigenschaften der unbelichteten Bereiche wesentlich verändert werden. Die Dauer des Erwärmens kann je nach Art der Wärmeeinwirkung sehr unterschiedlich sein. Bei Übertragung durch ein Wärmemedium liegt sie im allgemeinen zwischen 10 Sekunden und 10 Minuten, vorzugsweise zwischen 1 und 3 Minuten. Nach dem Erwärmen und Abkühlen wird die lichtempfindliche Schicht einer Totalbelichtung unterworfen um die noch lichtempfindlichen Schichtbereiche vollständig in ihre Lichtzersetzungsprodukte umzuwandeln. Die Nachbelichtung kann vorteilhaft unter der gleichen Lichtquelle erfolgen, die zur Bildbelichtung verwendet wurde.

An die Nachbelichtung schließt sich eine Entwicklung mit üblichen Entwicklern an, wobei die Schichtbereiche ausgewaschen werden, die bei der ursprünglichen Bildbelichtung nicht vom Licht getroffen worden waren. Das erfindungsgemäße Gemisch hat den Vorteil, daß bei guter Lagerfähigkeit, auch bei angehobenen Temperaturen, die Aushärtung der bildmäßig belichteten Schichtbereiche in der Wärme relativ schnell erfolgt.

Mit dem erfindungsgemäßen Kopiermaterial lassen sich außer der Herstellung einer Negativ-Kopie von der normalerweise positiv-arbeitenden Kopierschicht auch vorteilhaft verschiedene Kombinationsmöglichkeiten beim Zusammenkopieren von Strich-und Rasterfilmen verwirklichen (Photocomposing). So kann man beispielsweise unmittelbar nach der ersten bildmäßigen Belichtung unter einer Negativ-Vorlage nachträglich an den noch nicht vom Licht getroffenen Schichtbereichen, die während der ersten Belichtung durch eine Maske abgedeckt waren, mit Hilfe einer Positiv-Vorlage zusätzlich noch ein weiteres Strich- oder Rasterbild einkopieren. Die so belichtete Druckplatte wird anschließend ohne weitere Zwischenschritte entwickelt, wobei die fertige Druckform erhalten wird. Durch die vielfältigen Kombinationsmöglichkeiten beim Zusammenkopieren von Positiv-und Negativfilmen auf ein- und dieselbe Druckplatte werden bemerkenswerte Einsparungen an Zeit und Material erzielt.

Als lichtempfindliche Verbindungen in dem erfindungsgemäßen lichtempfindlichen Gemisch eignen sich alle positiv arbeitenden Verbindungen, d.h. solche, die durch Belichten in einem wäßrig-alkalischen Entwickler löslich werden. Hierzu gehören o-Chinondiazide und Kombinationen von photolytischen Säurespendern und säurespaltbaren Verbindungen, wie Orthocarbonsäure- und Acetalverbindungen.

Das erfindungsgemäße Gemisch und Verfahren haben besondere Vorteile in Verbindung mit lichtempfindlichen Materialien auf Basis von o-Chinondiaziden, da deren Auflage durch Einbrennen eine besonders große Erhöhung erfährt.

Geeignete Materialien sind bekannt und beispielsweise in der DE-OS 28 28 037 entsprechend US-PS 4,266,001 beschrieben. Als o-Chinondiazide werden bevorzugt Naphthochinon-(1,2)-diazid-(2)-4-oder 5-sulfonsäureester oder -amide verwendet. Von diesen werden die Ester, insbesondere die der 5-Sulfonsäure, besonders bevorzugt. Die Mengen an o-Chinondiazidverbindungen beträgt im allgemeinen 3 bis 50, bevorzugt 7 bis 35 Gewichtsprozent, bezogen auf die nichtflüchtigen Anteile des Gemisches.

Auch Materialien auf Basis säurespaltbarer Verbindungen lassen sich mit gutem Effekt einbrennen und bei dem erfindungsgemäßen Verfahren einsetzen.

Kopiermaterialien dieser Art sind bekannt und z.B. in den US-A 3,779,778, 4,101,323, DE-PS 27 18 254 entsprechend US-PS 4,247,611 beschrieben. Sie enthalten als säurespaltbare Verbindungen Orthocarbonsäurederivate, monomere oder polymere Acetale, Enolether oder Acyliminocarbonate. Als strahlungsempfindliche, Säure abspaltende Verbindungen enthalten sie vorwiegend organische Halogenverbindugnen, insbesondere durch Halogenmethylgruppen substituierte s-Triazine.

Von den in der US-A 4,101,323 beschriebenen Orthocarbonsäurederivaten werden besonders die Bis-1,3-dioxan-2-yl-ether von aliphatischen Diolen verwendet.

Von den in der DE-PS 27 18 254 entsprechend US-PS 4,247,611 beschriebenen Polyacetalen werden diejenigen mit aliphatischen Aldehyd- und Dioleinheiten bevorzugt.

Der Mengenanteil der säurespaltbaren Verbindungen in dem lichtempfindlichen Gemisch liegt im allgemeinen zwischen 8 und 65, vorzugsweise zwischen 14 und 44 Gewichtsprozent, bezogen auf die nichtflüchtigen Bestandteile des Gemischs. Die Menge der Säure abspaltenden Verbindung liegt zwischen 0,1 und 10, vorzugsweise zwischen 0,2 und 5 Gewichtsprozent.

Die erfindungsgemäßen lichtempfindlichen Gemische enthalten ferner ein polymeres, wasserunlösliches harzartiges Bindemittel, das sich in den für das erfindungsgemäße Gemisch verwendeten Lösemitteln löst und in wäßrigen Alkalien löslich oder zumindest quellbar ist.

Die bei vielen Positiv-Kopiermaterialien auf Basis von 1,2-Chinondiaziden bewährten Novolak-Kondensationsharze haben sich als Zusatz auch bei den erfindungsgemäßen Gemischen als besonders brauchbar erwiesen. Sie fördern die starke Differenzierung zwischen den belichteten und unbelichteten Schichtpartien beim Entwickeln, besonders die höher kondensierten Harze mit substituierten Phenolen, z.B. Kresolen, als Formaldehyd-Kondensationspartner. Die Art und Menge der Novolak-Harze kann je nach Anwendungszweck verschieden sein; bevorzugt sind Novolak-Anteile am Gesamtfeststoff zwischen 90 und 50, besonders bevorzugt von 75 - 60 Gewichtsprozent. Zusätzlich können noch zahlreiche andere Harze mitverwendet werden, bevorzugt Vinylpolymerisate wie Polyvinylacetate, Polyacrylate, Polyvinylether, Polyvinylacetale, Polyvinylpyrrolidone und die Mischpolymerisate der ihnen zugrundeliegenden Monomeren. Der günstigste Anteil an diesen Harzen richtet sich nach den anwendungstechnischen Erfordernissen und dem Einfluß auf die Entwicklungsbedingungen und beträgt im allgmeinen nicht mehr als 20 Gewichtsprozent vom alkalilöslichen Harz.

In geringen Mengen kann das lichtempfindliche Gemisch für spezielle Erfordernisse wie Flexibilität, Haftung, Glanz, Färbung und Farbumschlag etc. außerdem noch Substanzen wie Polyglykole, Cellulose-Derivate wie Ethylcellulose, Netzmittel, Farbstoffe, Haftvermittler und feinteilige Pigmente sowie bei Bedarf UV-Absorber enthalten. Als weitere alkalilösliche bzw. in Alkali quellbare Bindemittel sind natürliche Harze wie Schellack und Kolophonium und synthetische Harze wie Mischpolymerisate aus Styrol und Maleinsäureanhydrid oder Mischpolymerisate der Acrylsäure oder Methacrylsäure, insbesondere mit Acryl- oder Methacrylsäureestern zu nennen.

Die Erfindung betrifft auch ein lichtempfindliches Kopiermaterial, bestehend aus einem Schichtträger und einer lichtempfindlichen Schicht, das dadurch gekennzeichnet ist, daß die Schicht aus dem erfindungsgemäßen Gemisch besteht.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone, wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykol-monoethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren.

Als Schichtträger für Schichtdicken unter ca. 10 µm werden meist Metalle verwendet. Für Offsetdruckplatten können eingesetzt werden: walzblankes, mechanisch oder elektrochemisch aufgerauhtes und gegebenenfalls anodisiertes Aluminium, das zudem noch chemisch, z.B. mit Polyvinylphosphonsäure, Silikaten, Hexafluorozirkonaten, hydrolisiertem Tetraethylorthosilikat oder Phosphaten, vorbehandelt sein kann, außerdem Mehrmetallplatten mit Cu/Cr oder Messing/Cr als oberster Schicht. Für Hochdruckplatten können die erfindungsgemäßen Schichten auf Zink- oder Magnesium-Platten sowie deren handelsübliche mikrokristalline Legierungen für Einstufenätzverfahren aufgetragen werden, außerdem auf ätzbare Kunststoffe wie Polyoxymethylen. Für Tiefdruck- oder Siebdruckformen eignen sich auch die erfindungsgemäßen Schichten durch ihre gute Haftung und Ätzfestigkeit auf Kupfer- bzw. Nickel-Oberflächen. Ebenso lassen sich die erfindungsgemäßen Gemische als Photoresists verwenden.

Die Beschichtung des Schichtträgers erfolgt in bekannter Weise durch Aufschleudern, Sprühen, Tauchen, Walzen mittels Breitschlitzdüsen, Rakeln oder durch Gießer-Antrag.

Zum bildmäßigen Belichten können die üblichen Kopiergeräte wie Röhrenlampen, Xenonimpulslampen, metallhalogeniddotierte Quecksilberdampflampen und Kohlenbogenlampen verwendet werden.

Die zum Entwickeln verwendeten wäßrig-alkalischen Lösungen abgestufter Alkalität, d.h. mit einem pH, der bevorzugt zwischen 10 - 14 liegt, und die auch kleinere Mengen organischer Lösungs- oder Netzmittel enthalten können, entfernen die vom Licht betroffenen Stellen der Kopierschicht und erzeugen so ein positives Abbild der Vorlage.

Bevorzugte Anwendung finden die erfindungsgemäßen Gemische bei der Herstellung von Druckformen, insbesondere Offsetdruckformen, mit Aluminium als Schichtträger.

Nach dem Entwickeln wird die Druckform in an sich bekannter Weise erhitzt. Im Gegensatz zu den bisher beim Einbrennen üblichen Verfahrensbedingungen, wie sie z.B. in der GB-PS 1,154,749 oder der DE-OS 29 39 785 entsprechend US-PS 4,191,570 angegeben sind, ist es bei Zusatz der erfindungsgemäß beanspruchten Melamin-Formaldehyd-Harze möglich, die gleiche Erhöhung der Druckauflage wie bisher jedoch bei deutlich tieferen Temperaturen bzw. innerhalb wesentlich kürzeren Zeiten zu erreichen. Die Einbrenntemperaturen können im Bereich von etwa 150 bis 240 °C, vorzugsweise von 180 bis 220 °C, gewählt werden, wobei normalerweise Erhitzungszeiten von 1 bis 12, bevorzugt 3 bis 5 Minuten, erforderlich sind. Wenn der Schichtträger gegen höhere Temperaturen beständig ist, ist es selbstverständlich auch möglich, bei höheren Temperaturen oberhalb 240 °C einzubrennen und dementsprechend kurze Erhitzungszeiten zu wählen.

Der nach dem Entwickeln des Bildes freigelegte Schichtträger kann auch in bekannter Weise vor dem Erhitzen mit der wäßrigen Lösung einer filmbildenden Substanz behandelt werden, um die Nachentwicklung nach dem Erhitzen zwecks Entfernung der an den bildfreien Stellen mitunter auftretenden Hintergrundverschmutzungen einzusparen oder zumindest zu erleichtern. Diese Behandlung kann auch bei dem erfindungsgemäßen Verfahren nützlich sein, sie ist jedoch nicht unbedingt erforderlich. Insbesondere bei Anwendung der bevorzugten niedrigen Einbrenntemperaturen bilden sich meist gar keine oder leicht entfernbare Niederschläge auf den Hintergrundstellen des Schichtträgers.

Bei der bevorzugten Durchführung des Verfahrens kann deshalb auf diesen Schritt verzichtet werden.

Durch das Erhitzen der Druckform auf die oben genannten Temperaturen wird eine Verfestigung der Kopierschicht und damit eine erhebliche Erhöhung der Druckauflage erreicht. In Gegenwart der erfindungsgemäß thermisch vernetzenden Melamin-Formaldehyd-Harze können die Einbrenntemperaturen bzw. die Einbrennzeiten wesentlich gesenkt werden, was sowohl bei manueller als auch bei automatischer Verarbeitung zu einer nicht unerheblichen Zeitersparnis führt. Ferner wird die bei höheren Einbrenntemperaturen oder bei längeren Einbrennzeiten bestehende Gefahr, daß sich die üblicherweise verwendeten Schichtträger aus Aluminum verformen und die erhaltenen Druckformen geschädigt oder unbrauchbar werden, beseitigt.

Die Erfindung wird anhand des nachfolgenden Beispiels näher erläutert, in denen Gewichtsteile (Gt) und Volumenteile (Vt) im Verhältnis von g zu cm³ stehen. Prozente sind, wenn nichts anderes angegeben ist, Gewichtsprozente.

### Beispiel 1:

Mit einer Lösung von
1,50 Gt des Veresterungsproduktes aus 1 Mol 2,3,4-Trihydroxybenzophenon und 3 Mol Naphthochinon-(1,2)-diazid-(2)-4-sulfonsäurechlorid,
8,00 Gt des in Beispiel 1 angegebenen Novolaks,
0,20 Gt eines nichtplastifizierten, mit Methanol und Butylglykol verethertes Melamin-Formaldehyd-Harz mit einem mittleren Molekuklargewicht von ca. 1000 (Maprenal® der HOECHST AG)
0,20 Gt Naphthochinon-(1,2)-diazid-(2)-4-sulfonsäurechlorid,
0,07 Gt Kristallviolett in
60,00 Gt Ethylenglykolmonomethylether und
60,00 Gt Tetrahydrofuran
wurde eine elektrochemisch aufgerauhte und anodisierte Aluminiumplatte beschichtet, deren Oberfläche mit einer wäßrigen Lösung von Polyvinylphosphonsäure behandelt worden war. Zur Verfestigung der Druckplatte war eine Einbrennzeit von 5 Minuten bei 200 °C ausreichend.

## Patentansprüche

1. Lichtempfindliches Gemisch, das im wesentlichen ein wasserunlösliches, in wäßrig-alkalischen Lösungen lösliches Bindemittel, eine thermisch vernetzende Verbindung und entweder a) ein lichtempfindliches 1,2-Chinondiazid oder b) eine bei Belichtung Säure abspaltende Verbindung und eine Verbindung mit mindestens einer durch Säure spaltbaren C-O-C-Gruppe enthält, dadurch gekennzeichnet, daß als thermisch vernetzende Verbindung ein nicht gehärtetes, mit niederen Glykolen verethertes Melamin-Formaldehyd-Harz mit einem Molekulargewicht im Bereich von etwa 500 bis 1.500 vorhanden ist.

2. Gemisch gemäß Anspruch 1, dadurch gekennzeichnet, daß die thermisch vernetzende Verbindung in einer Menge von etwa 0,5 bis 5 Gewichtsprozent, bezogen auf das Trockengewicht des Gemisches, vorhanden ist.

3. Gemisch gemäß Anspruch 1 oder 2, dadurch gekennzeichnet, daß die thermisch vernetzende Verbindung ein nicht plastifiziertes, mit Methanol und Butylglykol verethertes Melamin-Formaldehyd-Harz ist.

4. Gemisch gemäß einem oder mehreren der Ansprüche 1 bis 3, dadurch gekennzeichnet, daß das Bindemittel ein Novolak ist.

5. Gemisch gemäß gemäß einem oder mehreren der Ansprüche 1 bis 4, dadurch gekennzeichnet, daß das 1,2-Chinondiazid ein Veresterungsprodukt aus 2,3,4-Trihydroxy-benzophenon und 1,2-Naphthochinon-2-diazid-4- oder -5-sulfonylchlorid ist.

6. Gemisch gemäß einem oder mehreren der Ansprüche 1 bis 4, dadurch gekennzeichnet, daß das 1,2-Chinondiazid ein Veresterungsprodukt aus 4-(2-Phenyl-prop-2-yl)-phenol und 1,2-Naphthochinon-2-diazid-4-sulfonylchlorid ist.

7. Lichtempfindliches Kopiermaterial aus einem Träger und einer lichtempfindlichen Schicht, dadurch gekennzeichnet, daß die Schicht aus einem Gemisch gemäß einem oder mehreren der Ansprüche 1 bis 6 besteht.

## Claims

1. A photosensitive mixture which essentially contains a water-insoluble binder which is soluble in aqueous alkaline solutions, a thermally cross-linking compound and either a) a photosensitive 1,2-quinone-diazide or b) a compound which splits off acid on exposure to light and a compound containing at least one C-O-C group which can be split by acid, characterized in that an uncured melamine-formaldehyde resin etherified with lower glycols and having a molecular weight in the range from about 500 to 1,500 is present as thermally crosslinking compound.

2. A mixture as claimed in claim 1, wherein the thermally crosslinking compound is present in a quantity of about 0.5 to 5 percent by weight referred to the dry weight of the mixture.

3. A mixture as claimed in claim 1 or 2, wherein the thermally crosslinking compound is an unplasticized melamine-formaldehyde resin etherified with methanol and butyl glycol.

4. A mixture as claimed in one or several of claims 1 to 3, wherein a novolak is present as binder.

5. A mixture as claimed in claim 1, wherein an esterification product of 2,3,4-trihydroxybenzophenone and 1,2-naphthoquinone-2-diazide-4-sulfonic acid chloride or -5-sulfonic acid chloride is present as 1,2-quinonediazide.

6. A mixture as claimed in one or several of claims 1 to 4, wherein an esterification product of 4-(2-phenylprop-2-yl)phenol and 1,2-naphthoquinone-2-diazide-4-sulfonic acid chloride is present as 1,2-quinonediazide.

7. A photosensitive copying material consisting of a support and a photosensitive layer, wherein said layer is comprised of a mixture as claimed in one or several of claims 1 to 6.

## Revendications

1. Composition photosensible contenant principalement un liant non soluble dans l'eau qui est soluble dans des solutions aqueuses alcalines, un composé de réticulation par voie thermique, et a) un composé photosensible de type 1,2-quinonediazide ou bien b) un composé qui libère un groupe acide lors d'une exposition à la lumière et un composé contenant au moins un groupe C-O-C qui peut être décomposé par un acide et caractérisée en ce qu' une résine non durcie mélamine-formaldéhyde, éthérifiée avec des glycols inférieurs et ayant un poids moléculaire compris entre 500 et 1.500, est présente en tant que composé de réticulation par voie thermique.

2. Composition selon la revendication 1, le composé de réticulation par voie thermique caractérisée en ce que est présent selon une quantité comprise entre 0,5 et 5 % en poids par rapport au poids de la composition à sec.

3. Composition selon la revendication 1 ou 2, caractérisée en ce que le composé de réticulation par voie thermique est une résine mélamine-formaldéhyde non plastifiée, éthérifiée avec du méthanol et du butyl glycol.

4. Composition selon une ou plusieurs des revendications 1 à 3, caractérisée en ce qu' une résine novolaque est présente en tant que liant.

5. Composition selon une ou plusieurs des revendications 1 à 4, caractérisée en ce qu' un produit d'estérification de la 2,3,4-trihydroxybenzophénone et du chlorure d'acide 1,2-naphthoquinone-2-diazide-4-sulfonique ou du chlorure d'acide 1,2-naphtoquinone-2-diazide-5-sulfonique est présent en tant que composé de type 1,2-quinonediazide.

6. Composition selon une ou plusieurs des revendications 1 à 4, caractérisée en ce qu' un produit d'estérification du 4-(2-phénylprop-2-yl)phénol et du chlorure d'acide 1,2-naphtoquinone-2-diazide-4-sulfonique est présent en tant que composé 1,2-quinonediazide.

7. Matériau d'enregistrement photosensible consistant en un support et en une couche photosensible caractérisé en ce que la couche est constituée par une composition selon une ou plusieurs des revendications 1 à 6.
